# EUROPEAN PATENT APPLICATION

(11) **EP 2 889 653 A1**
(43) Date of publication of application: **01.07.2015**
(21) Application number: 13382577.8
(22) Date of filing: 30.12.2013
(51) Int. Cl.: G02B 3/08, H01L 31/052

(54) **Chromatic aberration corrected lens for photovoltaic concentrators**

(71) Applicant: Universidad Politécnica de Madrid, 28040 Madrid (ES)
(72) Inventor: Sala Pano, Gabriel, E-28040 Madrid (ES); Askins, Stephen, E-28040 Madrid (ES); Antón Hernández, Ignacio, E-28031 Madrid (ES); Victoria Perez, Marta, E-28040 Madrid (ES)
(74) Representative: ABG Patentes, S.L.

(57) **Abstract**

The present invention relates to a lens having limited chromatic aberration for photovoltaic concentrators comprising a doublet formed by two individual lenses, a first individual rigid diverging lens and a second individual converging lens, where the material of the first individual diverging lens has greater dispersion than the material of the second individual elastomeric converging lens, and further comprising a transparent rigid support extending essentially in a principal plane perpendicular to the focal axis of the doublet of individual lenses. The elastomer occupies the space between the first individual rigid diverging lens and the rigid support.

## Description

### Object of the Invention

The present invention relates to a lens having limited chromatic aberration for photovoltaic concentrators.

Said lens is formed by attaching a rigid support to a doublet formed by a first individual rigid diverging lens and a second individual elastomeric converging lens.

Since this lens has limited chromatic aberration, it concentrates the light much more than a conventional lens, producing an image at the focus that is almost as small as that which an ideal system would produce. It therefore allows a refractive optical transmission system with high concentration and high angular acceptance to be obtained without the need for a secondary optic. Furthermore, it allows for the manufacturing of sets of multiple individual lenses.

The invention also includes a method of manufacturing the aforementioned lens which provides the capability to manufacture the second individual elastomeric converging lens by conforming it to the rigid support and the first individual rigid diverging lens.

### Background of the Invention

Concentrating photovoltaics is a field of art under intense development whereby energy is produced by means of extremely sophisticated solar cells that offer high efficiency in converting sunlight into electricity.

Multijunction solar cells are very well adapted to the terrestrial solar spectrum and reach efficiencies of up to 45%. This efficiency is double the efficiency of the best conventional single-junction cells, so the capture surface of a photovoltaic system with multijunction cells will be approximately half of that which is needed for conventional cells.

The cost per unit area of multijunction solar cells in a system can be 100 times higher than that of conventional cells, so the concentrating optics are used to reduce their impact on the total cost of the system, given that said optics intensify the light on the cell several hundredfold, such that both the area and the impact thereof on the cost of the system can be reduced several hundredfold.

The concentrators used for this purpose are optical systems which are capable of focusing the light from the sun disc by means of refraction and reflection phenomena. Lenses are more commonly used than mirrors or reflectors, given that the receiving cells and the heat sinks can be placed under said lens without casting a shadow, as it occurs in the case of the mirrors, and given that the lens doubles as a seal for the module containing the receivers.

These lenses are manufactured using transparent plastic, typically polymethyl methacrylate (PMMA), and hybrid lenses made of flat glass and transparent silicone have also recently been produced, where the transparent silicone carries out the optical function of concentration by providing the structure of a Fresnel lens.

For white light, such as sunlight, the concentration that can be achieved by these lenses is less than that which the mirrors can achieve. Under sunlight, refractors produce chromatic aberration because the refractive index of the material used to manufacture them varies with wavelength. This phenomenon is inherent to materials; it is present in almost all concentrated photovoltaic (CPV) technology and considerably reduces maximum concentration by about four times, such that the maximum concentration that can be achieved is below 250X if light losses are to be prevented.

In order to overcome such a low concentration level, which reduces the competitiveness of CPV technology, a secondary concentration optic may be added to the cell which allows the concentration level to be improved while maintaining the angular acceptance.

Although this secondary optic is widely used, its added price, the difficulty of optically connecting it to the cell and the uncertainty as to its long-term reliability (due to expansions, high light intensity and thermal cycling during operation) mean that being able to avoid said secondary optic on the cell would be desirable.

Some first possible solutions to this problem are found in documents such as *"Flat Fresnel doublets made of PMMA and PC: combining low cost production and very high concentration ratio for CPV",* or *"Performance comparison of four kinds of flat non imaging Fresnel lenses made of polycarbonates and polymethyl methacrylate for concentrated photovoltaics",* both publications written by Fabian Languy. Description of the Invention

The technical problems discussed above are solved by means of the invention described below, comprising a lens having limited chromatic aberration according to claim 1, and a method of manufacturing said lens having limited chromatic aberration according to claim 9.

A first inventive aspect of the invention relates to a *lens having limited chromatic aberration for photovoltaic concentrators comprising a doublet formed by two individual lenses, a first individual diverging lens and a second individual converging lens, where the material of the first individual diverging lens has greater dispersion than the material of the second individual converging lens, characterized in that:*
- *it additionally comprises a transparent rigid support extending essentially in a principal plane perpendicular to the focal axis of the doublet of individual lenses;*
- *the first individual diverging lens is rigid; and,*
- *the second individual converging lens is formed by an elastomer occupying the space between the first individual diverging lens and the rigid support.*

Dispersion is the variation of the refractive index with wavelength, and is usually characterized in optics by means of the Abbe number. The value of said dispersion for the first individual rigid diverging lens must be greater (lower Abbe number) than the dispersion of the second individual elastomeric converging lens. These different dispersion values and the different materials forming the lenses, in addition to the selection of the focal distances of each virtual lens, give rise to a lens that considerably reduces chromatic aberration.

The support acts both as a support for the second individual elastomeric converging lens and as a counter mold, together with the first individual rigid diverging lens, for the forming of said second individual elastomeric converging lens.

The support and the individual diverging lens are rigid, where rigid is taken to mean that the resistance to deformation is enough for the manufacturing process to confer a shape to the elastomer that fills the space between the first individual rigid lens and said support.

The rigid support is located principally on a plane perpendicular to the focal axis of the individual lenses. The focal axis of a lens is the optical axis of the lens. If the lens is symmetrical with respect to a line passing through the focal point, then the focal axis is said line. If the lens is cylindrical, then the focal axis is interpreted as the line of intersection between the cross-sectional plane of the lens and the plane of symmetry perpendicular to the cross-sectional plane.

The lens having limited chromatic aberration according to the invention considerably reduces the chromatic effect that is generated with known lenses and it provides advantages, such as drastically simplifying the ability to achieve very high levels of concentration with a single-stage refractive optic for solar energy applications. Concentration levels of greater than 800X can be achieved with a single-stage optic whereas conventional lenses only achieve 300X for the same efficiency.

The structure of the lens having limited aberration assures correct adaptation of the elastomeric lens to the shape of the rigid diverging lens, mainly at the interface between both lenses, because it allows a method of manufacture in which the elastomeric lens is formed such that it occupies the space defined between the rigid support and the rigid lens.

A second inventive aspect of the invention relates to a *method of manufacturing a lens having limited chromatic aberration for photovoltaic concentrators comprising the following steps:*
*a) providing a first individual rigid diverging lens;*
*b) providing a support extending essentially in a plane perpendicular to the focal axis of the individual rigid diverging lens;*
c) *providing an elastomer capable of being, at least once, in a first state in liquid conditions and of being in a second state in a solid condition;*
*d) incorporating the elastomer in the first state in liquid conditions in the space defined between the first individual rigid diverging lens and the support such that said elastomer occupies the space between the first individual diverging lens and said support in at least one region of the support;*
*e) causing the elastomer to change from the first state in liquid conditions to the second state in a solid condition.*

The arrangement between the first individual rigid diverging lens and the support verifying condition b) defines a space between both components which is the space intended for being occupied by the elastomer.

The elastomer must allow two states, a first state in liquid conditions and a second state in a solid condition. The liquid condition must be interpreted as the elastomer being capable of flowing and therefore adapting to the shape of the surface demarcating the space where it is located, particularly the surface of the support and the surface of the individual rigid lens. Said liquid condition can be the characteristic condition of the elastomer at room temperature or it can be reached under certain temperature and pressure conditions.

The second solid condition must be interpreted as the elastomer no longer flowing in that second condition, maintaining the adopted shape as the final shape. That does not mean that the elastomer cannot be readily deformable in response to applying pressure, for example.

This method allows first manufacturing the first individual rigid diverging lens, and it then allows manufacturing the second individual elastomeric converging lens using said first individual rigid diverging lens as the mold and the rigid support as the counter mold.

Incorporating the elastomer between the individual rigid diverging lens and the rigid support in the first state in a liquid condition allows the elastomer to adopt the suitable shape of the elastomeric lens, and changing to the solid condition allows this shape to remain stable.

The moment in which the space between the individual rigid diverging lens and the rigid support is established and the incorporation of the elastomer can differ according to several embodiments, some of which will be described in detail below. Nevertheless the following two different sequences over time are of particular interest:
- a first sequence over time in which the space between the individual rigid diverging lens and the rigid support is first established, then the elastomer in the first state in a liquid condition is incorporated between said space such that the elastomer adopts the shape conferred by the rigid components, and then the change of state to a solid condition is performed, maintaining this stable form; or
- a second sequence over time in which the elastomer is first arranged either on the individual rigid diverging lens or on the rigid support, providing the elastomer according to the first state in a liquid condition and then placing the remaining rigid element on which the elastomer has not been arranged, such that said elastomer adopts the appropriate shape conferred by the two rigid elements which are now defining the space that must be occupied by the elastomer.

This second sequence corresponds to various examples, such as the use of an elastomer in solid form which is arranged before closing the space between the two rigid elements and passes to the liquid state due to a heating process, a pressure process, or a combination of both. Another embodiment according to this second sequence corresponds to the use of liquid elastomers whose high viscosity allows them to remain in position in a slow flow while a second rigid element is being applied thereon. Another embodiment uses elastomers which, although they flow readily because they do not have such a high viscosity as in the preceding example, are retained upon the first rigid element by means of additional containment means. In this case, the containment means are sides because the direction of gravity is what defines what is down below, up above or on a side.

The method thus allows a doublet of lenses from materials having a different dispersion in order to obtain a lens that considerably reduces the chromatic aberration effect to be formed.

The properties of the second individual elastomeric converging lens will be obtained according to the material forming said lens.

### Description of the Drawings

These and other features and advantages of the invention will be more clearly understood based on the following detailed description of a preferred embodiment given only as a nonlimiting, illustrative example in reference to the attached drawings.
Figure 1 shows a general side view of the distribution of the lens having limited chromatic aberration in a first embodiment.
Figure 2 shows a side view of the distribution of the lens having limited chromatic aberration in another embodiment.
Figure 3 shows a side view of the distribution of the lens having limited chromatic aberration as it is shown in the preceding figure, where the support is formed by a temporary rigid support and a sheet in this new embodiment.

### Detailed Description of the Invention

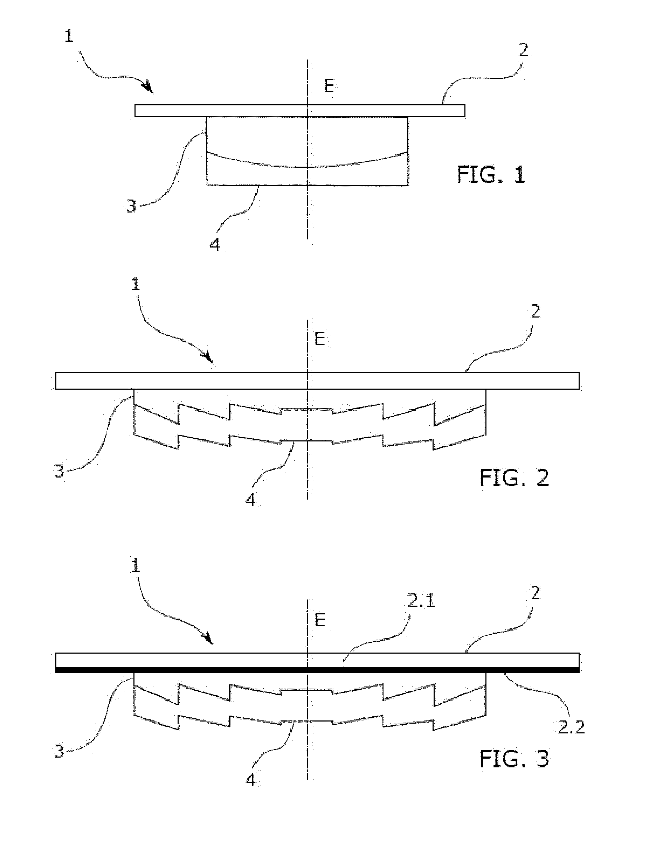

According to the first inventive aspect and as shown in Figure 1, the present invention relates to a lens (1) having limited chromatic aberration for photovoltaic concentrators, comprising a doublet formed by two individual lenses, a first individual rigid diverging lens (4) and a second individual converging lens (3) formed by an elastomer, and a transparent rigid support (2) extending essentially in a principal plane perpendicular to the focal axis (E) of the doublet of individual lenses (3, 4). The second individual elastomeric converging lens (3) occupies the space between the first individual rigid diverging lens (4) and the rigid support (2).

The side view of Figure 2 shows, for this example, how the first individual rigid diverging lens (4) has a Fresnel configuration on the surface in contact with the second individual elastomeric converging lens (3) and also on the opposite surface that is in contact with the air. The Fresnel teeth of the two faces of the first individual rigid diverging lens make these faces, without the presence of the second individual elastomeric converging lens (3) and the rigid support (2), act overall like net diverging lenses.

The rigid support (2), acting both as a support for the doublet of individual lenses (3, 4) and as a counter mold for manufacturing the second individual converging lens (3), is preferably a flat plate, specifically a sheet of transparent plastic or glass. In this case, since the transparent plastic or glass is not optically active, the lens (1) is applicable to sources of light that project a collimated beam, like the sun.

A variation of the lens (1) having limited chromatic aberration can also be obtained by replacing the rigid support (2) with a thin sheet (about 200 microns) of polymethyl methacrylate (PMMA), polyvinyl fluoride (tedlar), or glass that is temporarily supported on a rigid reinforcing support that is removed after manufacture, and where the purpose of this sheet during operation is to prevent contamination of the second individual elastomeric converging lens (3).

The first individual rigid diverging lens (4) is preferably made of a transparent, readily moldable material that has high form and surface finish precision and acquires a rigid consistency. Examples for this application are polycarbonate, PC, or polymethyl methacrylate, PMMA. Both materials are hard, rigid and non-deformable when comparing the hardness values and Young's modulus of said materials with the values of the elastomeric material.

The second individual elastomeric converging lens (3) is preferably made of a transparent elastomer which has low dispersion, can be molded to obtain said converging function, and has adhesive capacity, so it acts as an adhesive between the first individual rigid diverging lens (4) and the rigid support (2). Examples for this application are optically transparent silicone or ethyl vinyl acetate, EVA.

As seen in Figure 2, the face of the first individual rigid diverging lens (4) in contact with the elastomer (3) allows molding the curves or teeth characteristic of a converging lens in said elastomer (3). The teeth molded on the elastomer, together with the teeth of the first lens on its surface that is in contact with the air, are the teeth that will perform the effective focusing or concentration of the light on the solar cell.

Achromatic systems having a large surface area with a plurality of focal point lenses can be obtained from a plurality of lenses (1) having limited chromatic aberration.

In a particular embodiment of the invention, a compound lens comprising a plurality of lenses (1) distributed in a plane, where the rigid support (2) is a common support in the plurality of individual lenses (1), is obtained.

In another particular embodiment of the invention, a compound lens comprising a plurality of lenses (1) distributed in a plane, where the plurality of first individual diverging lenses (4) are configured in one and the same part, is obtained.

According to the second inventive aspect, the invention further relates to a method of manufacturing a lens having limited chromatic aberration for photovoltaic concentrators.

In a first step of said method, a first individual rigid diverging lens (4) is provided. This first individual rigid diverging lens (4) is preferably obtained by means of a plastic molding process, either by means of injection molding (injection of PC or PMMA, whichever is appropriate), hot embossing or thermal roller embossing. The molding of the individual rigid diverging lens (4) generates a lens where both faces have a Fresnel profile. The part resulting from the manufacture could be a single lens or it could directly be a set consisting of several lenses.

In a second step of the method of manufacture, a support (2) extending essentially in a plane perpendicular to the focal axis (E) of the individual rigid diverging lens (4) is provided. Said support is preferably a flat plate made of transparent plastic or glass.

In a third step of the method of manufacture, an elastomer capable of being, at least once, in a first state in liquid conditions and of being in a second state in a solid condition is provided.

The advantage of the invention resides in the fact that the elastomeric material does not have to be molded separately, but rather it must fill the space between the support (2), which provides rigidity and can be used as a counter mold, and the individual rigid diverging lens (4).

In a first case in which the individual rigid diverging lens (4) is made of polycarbonate, PC, and the elastomer (3) is transparent silicone, the individual rigid diverging lens (4) is placed on the transparent rigid support (2), where said rigid support (2) forms a plane perpendicular to the focal axis (E) of the individual rigid diverging lens (4). If the process of manufacturing the polycarbonate lens produces a parquet consisting of several lenses, these lenses are placed on the rigid support (2), forming an array distribution in rows and columns. Then the elastomer (3) in liquid state together with a curing reagent is injected in the volume defined by the rigid support (2) and the rigid lens or lenses (4) made of PC. Then the elastomer (3) is cured according to one of the following alternatives:
- at room temperature, which produces slow and stress-free curing, or
- in an oven, increasing the curing temperature to 80°C, always below the degradation temperature of PC, which reduces the time needed for the curing process, or
- by means of ultraviolet light.

In a second case in which the individual rigid diverging lens (4) is made of polymethyl methacrylate, PMMA, and the elastomer (3) is transparent silicone, the individual rigid diverging lens (4) is placed on the transparent rigid support (2), where said rigid support (2) forms a plane perpendicular to the focal axis (E) of the individual rigid diverging lens (4). If a parquet made up of several lenses was produced in the PMMA manufacturing process, these lenses are placed on the rigid support (2), forming an array. Then the elastomer (3) in liquid state together with a curing reagent is injected in the volume defined by the rigid support (2) and the rigid lens or lenses (4) made of PMMA. Then the elastomer (3) is cured according to one of the following alternatives:
- at room temperature, which produces slow and stress-free curing, or
- in an oven, to reduce curing time, where the curing temperature must be less than 50°C to assure the stability of PMMA, i.e., below the degradation temperature of PMMA, or
- by means of ultraviolet light.

In a third case as shown in Figure 3, the support (2) is made of a thin sheet (2.2) (about 200 microns) of PMMA, tedlar, or glass; where the sheet (2.2) has been located on a temporary support (2.1), where the thin sheet (2.2) is in turn supported, said temporary support (2.1) is what provides rigidity to the sheet (2.2) during the manufacturing process. Once manufacturing has ended, this temporary support (2.1) is removed, leaving only the thin sheet (2.2) in contact with the elastomer (3). In this case, the individual rigid diverging lens (4) can be made of both PC and PMMA, said lens withstanding the rigidity of the assembly, unlike in the two preceding cases, where said rigidity was withstood by both the individual rigid diverging lens (4) and the transparent rigid support (2). If a parquet made up of several lenses was produced in the polycarbonate manufacturing process, these lenses are placed on the rigid support (2), the thin sheet (2.2) thus facing the individual rigid diverging lens (4), forming an array. Then the elastomer (3), in this case transparent silicone in liquid state, together with a curing reagent, is injected in the volume defined by the support (2) and the rigid diverging lens or lenses (4) made of PC or PMMA. Then the elastomer (3) is cured according to one of the following alternatives:
- at room temperature, which produces slow and stress-free curing, or
- in an oven, to reduce curing time, where the curing temperature must be less than 50°C to assure the stability of PMMA, i.e., below the degradation temperature of PMMA, or
- by means of ultraviolet light.

In a fourth case, in which the individual rigid diverging lens (4) is made of polycarbonate, PC, and the elastomer (3) is ethyl vinyl acetate, EVA, the elastomer (3) is placed in solid form, preferably as a sheet about 1 mm thick, on the transparent rigid support (2), and then the individual rigid diverging lens (4) is placed on the elastomer (3). If a parquet made up of several lenses was produced in the polycarbonate manufacturing process, these lenses are placed on the elastomer (3), forming an array. The sandwich formed by the individual rigid diverging lens or lenses (4) made of PC, the elastomer (3) and the transparent rigid support (2), which forms a plane perpendicular to the focal axis of the lens (E), are introduced in an oven, where a thermal cycle is performed while a vacuum is applied. The elastomer (3) liquefies when the temperature increases above 80°C and acquires the shape of the Fresnel teeth of the face of the individual rigid diverging lens or lenses (4) made of PC in contact with the elastomer (3). Pressure is applied between the outer faces of the transparent rigid support (2) and the individual rigid diverging lens or lenses (4) made of PC at the same time that a vacuum is applied to avoid the presence of bubbles inside the sandwich. The thermal cycle is completed by reducing the temperature such that the elastomer (3) solidifies after having filled the entire volume between the transparent rigid support (2) and the individual rigid diverging lens or lenses (4) made of PC.

In a fifth case, the individual rigid diverging lens (4) is made of polycarbonate, PC, and the elastomer (3) is ethyl vinyl acetate, EVA, while the support (2) consists of a thin sheet (2.2) (about 200 microns) of PMMA, tedlar, or glass. A rigid temporary support (2.1), where the thin sheet (2.2) is in turn supported to provide sufficient strength and rigidity to the thin sheet (2.2) during manufacture, has also been used in this example. Once the manufacturing process ends, this temporary support (2.1) is removed, leaving the thin sheet (2.2) in contact with the elastomer (3). In this case, the elastomer (3) is placed in solid form, preferably as a sheet about 1 mm thick, on the thin sheet (2.2), and then the individual rigid diverging lens (4) is placed on the elastomer (3). If a parquet made up of several lenses was produced by the process of manufacturing the individual rigid diverging lens (4), these lenses are placed on the elastomer (3) forming an array. The sandwich formed by the individual rigid diverging lens or lenses (4) made of PC, the elastomer (3) in solid form, preferably as a sheet about 1 mm thick, the thin sheet (2.2) and the temporary support (2.1) are introduced in a oven, where a thermal cycle is performed while a vacuum is applied. The EVA liquefies when the temperature increases above 80°C and acquires the shape of the Fresnel teeth of the face of the individual rigid diverging lens or lenses (4) made of PC in contact with the EVA. Pressure is applied between the outer faces of the support (2) and the individual rigid diverging lens or lenses (4) made of PC at the same time that a vacuum is applied to avoid the presence of bubbles inside the sandwich. The thermal cycle is completed by reducing the temperature such that the elastomer (3) solidifies, filling the entire volume between the thin sheet (2.2) located on the support (2) and the individual rigid diverging lens or lenses (4) made of PC.

## Claims

1. A lens having limited chromatic aberration for photovoltaic concentrators comprising a doublet formed by two individual lenses, a first individual diverging lens (4) and a second individual converging lens (3), where the material of the first individual diverging lens (4) has greater dispersion than the material of the second individual converging lens (3), **characterized in that**:
- it additionally comprises a transparent rigid support (2) extending essentially in a principal plane perpendicular to the focal axis of the doublet of individual lenses (3, 4);
- the first individual diverging lens (4) is rigid; and,
- the second individual converging lens (3) is formed by an elastomer occupying the space between the first individual diverging lens (4) and the rigid support (2).

2. The lens (1) according to claim 1, **characterized in that** the first individual diverging lens (4) has a Fresnel configuration on the surface in contact with the second individual converging lens (3).

3. The lens (1) according to claim 1 or 2, **characterized in that** the first individual diverging lens (4) has a Fresnel configuration on the surface opposite the surface in contact with the second individual converging lens (3).

4. The lens (1) according to claim 1, **characterized in that** the rigid support (2) is a flat plate, preferably a sheet of transparent plastic or glass.

5. The lens (1) according to any of the preceding claims, **characterized in that** the first individual diverging lens (4) is made of polycarbonate, PC, or polymethyl methacrylate, PMMA.

6. The lens (1) according to any of the preceding claims, **characterized in that** the second individual converging lens (3) is made of optically transparent silicone or ethyl vinyl acetate.

7. A compound lens comprising a plurality of lenses (1) according to any of the preceding claims distributed in a plane, where the rigid support (2) is a common support in the plurality of individual lenses (1).

8. A compound lens comprising a plurality of lenses (1) according to any of the preceding claims distributed in a plane, where the plurality of first individual diverging lenses (4) are configured in one and the same part.

9. A method of manufacturing a lens having limited chromatic aberration for photovoltaic concentrators comprising the following steps:
a) providing a first individual rigid diverging lens (4);
b) providing a support (2) extending essentially in a plane perpendicular to the focal axis of the individual rigid diverging lens (4);
c) providing an elastomer capable of being, at least once, in a first state in liquid conditions and of being in a second state in a solid condition;
d) incorporating the elastomer in the first state in liquid conditions in the space defined between the first individual rigid diverging lens (4) and the support (2) such that said elastomer occupies the space between the first individual diverging lens (4) and said support (2) in at least one region of the support (2);
e) causing the elastomer to change from the first state in liquid conditions to the second state in a solid condition.

10. The method according to claim 9, wherein the first individual rigid diverging lens (4) of step a) is obtained by plastic molding.

11. The method according to claim 10, where the plastic molding is performed by injection, hot embossing or thermal roller embossing.

12. The method according to claims 9 to 11, wherein the elastomer of step c) is a liquid elastomer that allows a curing reagent, giving rise to a state in solid conditions.

13. The method according to claim 12, wherein the elastomer, preferably silicone, is mixed with the reagent before step d), and step e) is brought about by means of curing the elastomer.

14. The method according to claim 13, wherein the elastomer is cured in an oven by heating the elastomer above room temperature and below the degradation temperature of the material of the individual rigid diverging lens (4).

15. The method according to claims 9 to 11, wherein the elastomer of step c) is a solid elastomer, preferably ethyl vinyl acetate, that melts when the temperature is raised; and where the elastomer is incorporated in step d) in the first liquid state according to the following steps:
- arranging the solid elastomer in the space defined between the first individual rigid diverging lens (4) and the support (2),
- raising the temperature of at least the solid elastomer to at least its melting temperature;
and where step e) is carried out by cooling the elastomer below its melting point.

16. The method according to claim 15, wherein in addition to raising the temperature of the elastomer above the melting temperature, a vacuum is applied to remove air bubbles in the elastomer.

17. The method according to claim 15 or 16, wherein in addition to raising the temperature of the elastomer above the melting temperature, a force for bringing the support (2) and the first individual diverging lens (4) closer together is applied.

18. The method according to any of claims 9 to 17, wherein the support (2) is
- either a transparent rigid support,
- or a transparent sheet which additionally has a rigid support that can be removed after step e).
